# EUROPÄISCHE PATENTSCHRIFT

(11) **EP 1 814 764 B1**
(45) Veröffentlichungstag und Bekanntmachung des Hinweises auf die Patenterteilung: **23.04.2008**
(21) Anmeldenummer: 05794598.2
(22) Anmeldetag: 14.10.2005
(51) Int. Cl.: B60R 16/02, H05K 3/34

(54) **ELEKTRONISCHE VORRICHTUNG**
ELECTRONIC DEVICE
DISPOSITIF ELECTRONIQUE

(30) Priorität: 26.11.2004 DE 102004057404; 16.12.2004 DE 102004060694
(43) Veröffentlichungstag der Anmeldung: 08.08.2007
(73) Patentinhaber: SIEMENS AKTIENGESELLSCHAFT, 80333 München (DE)
(72) Erfinder: JAKLIN, Ralf, 65835 Liederbach (DE); ULLRICH, Horst, 61137 Schöneck (DE)
(86) Internationale Anmeldenummer: PCT/EP2005/055267
(87) Internationale Veröffentlichungsnummer: WO 2006/056512

(56) Entgegenhaltungen:
- DE-A1- 4 208 765
- DE-A1- 19 503 778
- US-A- 6 160 708
- US-A1- 2002 149 916
- US-B1- 6 193 564

## Beschreibung

Die Erfindung betrifft eine elektronische Vorrichtung mit einem Gehäuse zur Aufnahme eines, eine elektronische Schaltung tragenden Trägersubstrats, wobei die elektronische Schaltung mit mindestens einer elektrischen Leitung kontaktiert ist, welche aus dem Gehäuse herausgeführt ist.

In der Kraftfahrzeugelektronik werden die elektronischen Schaltungen zur Steuerung einzelner Fahrzeugfunktionen auf einer Leiterplatte angeordnet, welche in einem Gehäuse direkt am Ort des anzusteuernden Stellantriebes angeordnet ist. Die elektronische Schaltung wird dabei über Kabel mit der Karosserieseite verbunden. Die Kontaktierung der Leiterplatte mit den Kabelenden erfolgt dahingehend, dass die Einzelleitungen des Kabels durch Löcher in die Leiterplatte eingefädelt und anschließend verlötet werden.

In der Massenproduktion führt dies zu einer hohen Fehlerquote bei der Herstellung derartiger Steuergeräte. Weiterhin ist nachteilig, dass sich die Lötverbindungen aufgrund hoher Vibrationsanforderungen im Kraftfahrzeug lockern, was zu elektrischen Ausfällen führt.

In der US 2002/0149916 A1, als nächstliegen der Stand der Technik betrachtet, ist ein Elektronikgerät beschrieben, umfassend ein Gehäuseteil mit wenigstens einer verschließbaren Öffnung und einem Steckerteil, in welchem Gehäuseteil eine Leiterplatte mit wenigstens einem darauf angeordneten elektrischen und/oder elektronische Bauelemente und elektrische Kontaktelemente angeordnet sind, welche mit dem Steckerteil elektrisch verbunden sind, um im Gehäuseinnenraum zu der wenigstens einen Öffnung hin abstehende, parallel zueinander verlaufende Enden aufweisen, welche Enden durch Kontaktöffnungen der Leiterplatte hindurchgeführt und mit der Leiterplatte leitend verbunden sind. Die Kontaktelemente sind auf einem nicht in die Kontaktöffnungen eingeführten Teil ihrer Länge mit elastisch verformbaren Abschnitten versehen und die Leiterplatte ist durch die derart ausgestalteten Kontaktelemente federnd in dem Gehäuseteil gelagert und zusätzliche durch Dämpfungselemente mit dem Gehäuseteil verbunden.

In der DE 195 03 778 A1 ist eine Anordnung aus einem Gehäuse, einer Schaltungsträgerplatte und in dem Gehäuse eingespritzten Zuleitungen beschrieben. Die Enden der Zuleitungen ragen frei in den Gehäuseinnenraum und sind in Kontaktstücke eingepresst, die an einer Schaltungsträgerplatte angebracht sind und darin vorgesehene Löcher umgeben.

Die US 6,193,564 B1 beschreibt eine elektrische Verbindungsanordnung, mit einem flächigen Basiselement, das mehrere in seinem Inneren geführte elektrische Leiter umfasst, die an ersten Leiterenden mit einer in einem Gehäuse vorgesehenen elektronischen Schaltung elektrisch verbindbar sind und die an ihren zweiten Leiterenden aus dem Basiselement hervorstehen. Dort ist ein Steckverbinderkörper angeordnet, der die zweiten Leiterenden in Art eines Steckergehäuses umfasst, wobei die zweiten Leiterenden die elektrischen Kontaktstifte des Steckverbinderkörpers bilden.

Die DE 42 08 765 A1 offenbart einen elektrischen Betriebskasten, insbesondere für Kraftfahrzeuge, mit einer oder mehreren durch Isolierungen voneinander getrennten Platinen mit auf diesen aufgebrachten gedruckten Schaltungen aus leitfähigem Material, auf denen Bauteile angeordnet sind. Die gedruckten Schaltungen auf den beiden Seiten einer Platine oder die gedruckten Schaltungen mehrerer Platinen sind mittels Stiften elektrisch leitend verbunden.

Die US 6,160,708 offenbart ein Steuergerät für ein Kraftfahrzeug mit einer Bodenplatte, einem Leiterbahnträger, einer von dem Leiterbahnträger kontaktierten elektronischen Schaltung und einem Gehäusedeckel. An die Bodenplatte schließt sich ein Kontaktierungspanel mit integral ausgebildeten Einpressöffnungen an. Aus einem das Kontaktierungspanel überlagernden Tragkörper stehen Leiterenden hervor, die in die Einpressöffnungen hineinragen und den Leiterbahnträgern elektrisch kontaktieren.

Der Erfindung liegt somit die Aufgabe zugrunde, eine elektronische Vorrichtung anzugeben, welche den erhöhten Vibrationsanforderungen im Kraftfahrzeug entspricht und trotzdem einfach und kostengünstig herstellbar ist.

Erfindungsgemäß wird die Aufgabe dadurch gelöst, dass die elektrische Leitung mit einem starren Kontaktelement eines Kontakthalters verbunden ist und dass das Kontaktelement zur Kontaktierung der elektronischen Schaltung in das Trägersubstrat eingeführt ist.

Der Vorteil der Erfindung besteht darin, dass eine vorgefertigte Unterbaugruppe, bestehend aus Kontaktelement, Kontakthalter und Leitung eine Verbindungstechnik darstellt, die besonders massenproduktionstauglich ist, da in nur einem Montageschritt alle für die elektrische Kontaktierung notwendigen Elemente montiert werden. Diese Verbindungstechnik verhindert darüber hinaus zuverlässig ein Lösen der Kontakte durch Erschütterungen im Kraftfahrzeug.

Vorteilhafterweise überragt das Kontaktelement den Kontakthalter mindestens einseitig, wobei die elektrische Leitung an einem Ende des Kontakthalters mit diesem verbunden ist. Zur Verbindung sind verschiedene Techniken möglich. So kann das Kontaktelement und die elektrische Leitung verlötet oder verschweißt sein. Alternativ ist die elektrische Leitung parallel zu dem einen Ende des Kontaktelementes positioniert, wobei beide miteinander vercrimpt oder versplicet sind.

In einer Ausgestaltung ist der Kontakthalter an eine, an der Gehäusewandung angeordnete Kontakthalteraufnahme eingesetzt und das Trägersubstrat auf dem Kontakthalter aufgesetzt. Durch die feste Installation des Kontakthalters am Gehäuse erfolgt eine Positionierung der Kontaktelemente zur Leiterplatte. Dadurch dient der Kontakthalter gleichzeitig als Justiereinrichtung für das Trägersubstrat.

Zur einfachen Montage des Kontakthalters weist die Kontakthalteraufnahme einen Aufsteckzapfen auf, welcher vom Kontakthalter hintergriffen ist. Dadurch wird der Kontakthalter einfach nur auf die Kontakthalteraufnahme aufgesteckt.

Zur geordneten Führung der Zuleitungen im Gehäuse weist die Kontakthalteraufnahme einen Sockel auf, in welchem Kabelaufnahmen ausgebildet sind.

Vorteilhafterweise ist über ein, mehrere elektrische Leitungen zusammenfassendes Kabel eine Dichtung geschoben, welche in eine Öffnung der Gehäusewandung eingeschoben ist. Diese Dichtung, welche einen Teil der Gehäusewandung darstellt, führt zu einem dichten Abschluss des Gehäuses und bildet mit dem Kabelhalter, den Kontaktelementen und dem Kabel eine vorfertigbare Baueinheit.

Die Erfindung lässt zahlreiche Ausführungsformen zu. Eine davon soll anhand der in der Zeichnung dargestellten Figuren erläutert werden.

Es zeigen:
- Fig. 1:: Darstellung des geschlossenen Steuergeräts,
- Fig. 2:: Steuergerät ohne Leiterplatte,
- Fig. 3:: Kontakthalter,
- Fig. 4:: Steuergerätgehäuse,
- Fig. 5:: Draufsicht auf das geschlossene Steuergerät,
- Fig. 6:: Schnittdarstellung gemäß Fig. 5.

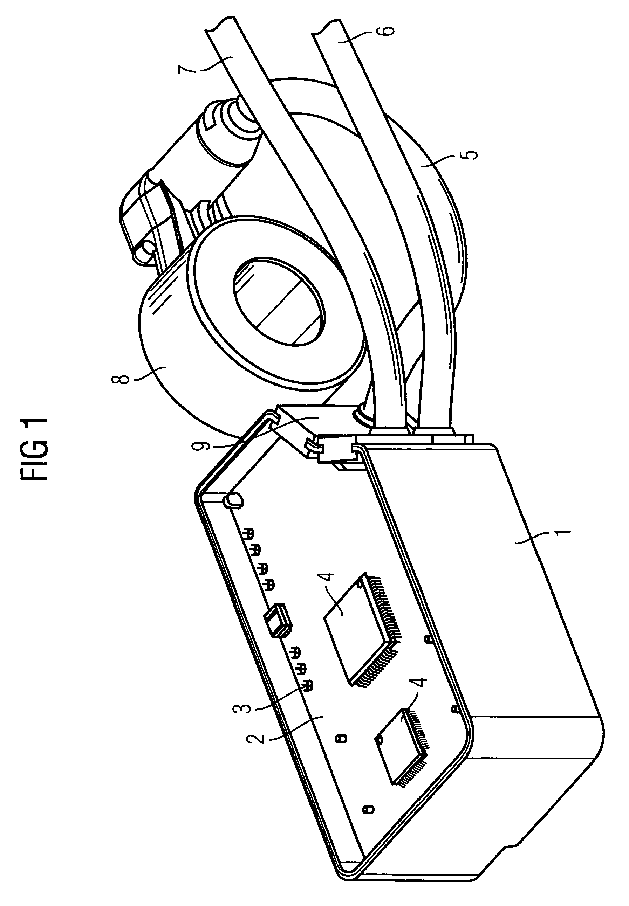

In Fig. 1 ist ein Steuergerät für den Einsatz am Stoßdämpfer eines Kraftfahrzeuges dargestellt, welche den Durchfluss der Hydraulikflüssigkeit durch ein Ventil regelt. Das Steuergerät weist ein einstückig ausgebildetes topfförmiges Gehäuse 1 auf, welches aus Kunststoff besteht und als Spritzgussteil hergestellt ist. Das Gehäuse 1 ist mit einer Leiterplatte 2 abgedeckt, welche elektrische Bauelemente 4 trägt, die die Regelung für das Stoßdämpferventil beinhalten. Durch die Kontaktöffnungen 3 der Leiterplatte 2 greifen die Anschlussdrähte der Kabel 5, 6, 7, die das Steuergerät mit der Umgebung elektrisch verbinden. Dabei ist die Leitung 5 mit einer Spule 8 verbunden, welche zur induktiven Energieübertragung des nicht weiter dargestellten Ventils dient. Das Gehäuse 1 weist an einer Seite Dichtungen 9 auf, die jeweils über ein Kabel 5, 6, 7 geschoben sind und gleichzeitig in die Gehäusewand als Teil der Gehäusewandung eingesetzt sind.

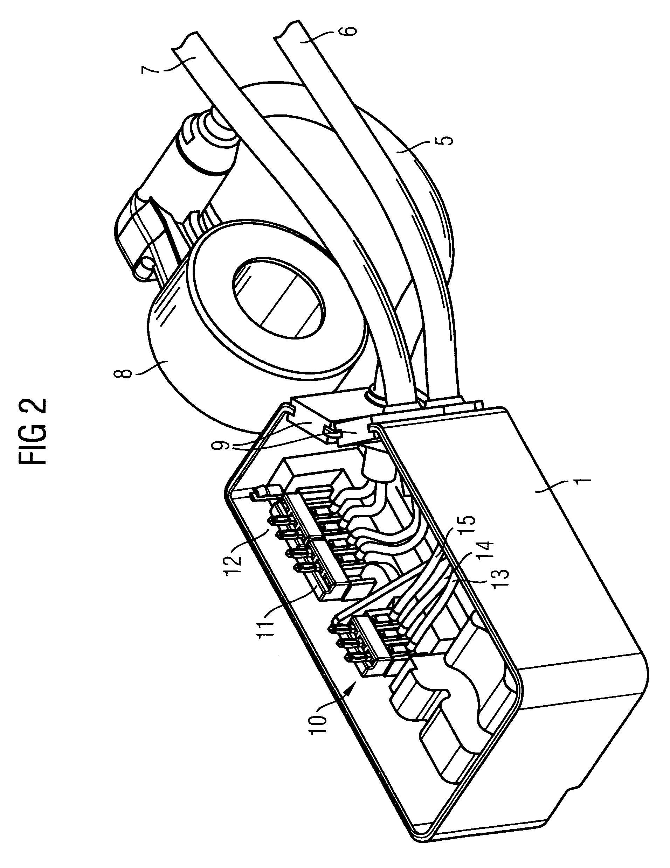

Das Gehäuse 1 ist ohne Leiterplatte, welche gleichzeitig als Deckel des Gehäuses dient, in Figur 2 dargestellt. Im Gehäuseinneren sind Kontakthalter 10, 11, 12 angeordnet, wobei an den Kontakthalter 10 die Adern 13, 14, 15 des Kabels 6 führen, während an die Kontakthalter 11 die Leitungen 39, 40 des Kabels 7 und an den Kontakthalter 12 die Leitungen 41,42 des Kabels 5 führen.

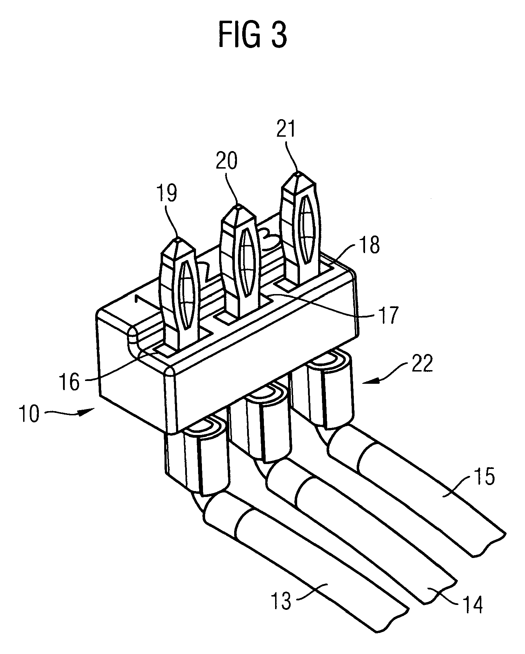

Der weitere Aufbau der Kontakthalter 10, 11, 12 soll am Beispiel des Kontakthalters 10 mit Hilfe von Fig. 3 erläutert werden. Der Kontakthalter 10 weist drei Öffnungen 16, 17, 18 auf, wobei in jede Öffnung ein starrer Einpresspin 19, 20, 21 derartig eingeführt ist, dass ein Teil des Einpresspins den Kontakthalter 10 oberhalb überragt. Diese Teile greifen dann in die Kontaktöffnungen 3 der Leiterplatte 2 ein. Die Einpresspins 19, 20, 21 ragen auch auf der Unterseite über den Kontakthalter 10 hinaus und sind dort mit dem abisolierten Teil der Leitungen 13, 14, 15 des Kabels 6 verbunden. In diesem Ausführungsbeispiel sind das untere Ende der Einpresspins 19, 20, 21 mit dem abisolierten Ende der Leitung 13, 14 bzw. 15 versplicet, indem die beiden Enden mit einem Metallblech 22 umwickelt und gequetscht sind.

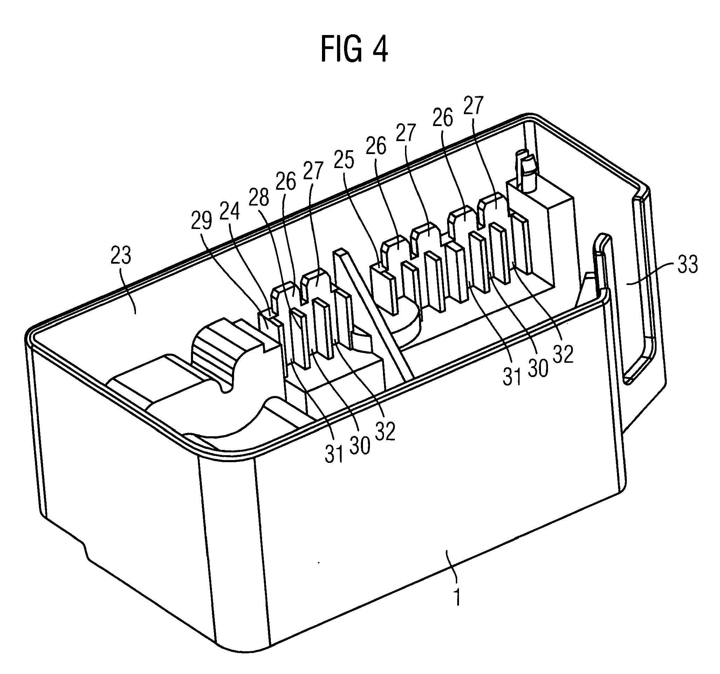

In Fig. 4 ist das topfähnliche Gehäuse 1 dargestellt, wobei an einer Seitenwand 23 Kontakthalteraufnahmen 24 und 25 einstückig aus dem Gehäuse ausgebildet sind. Diese Kontakthalteraufnahmen weisen Zapfen 26 und 27 auf. Diese Zapfen 26 und 27 sind an einem Sockel 29 angeformt, welcher durch Seitenwände 28 in verschiedene Kanäle 30, 31, 32 aufteilt ist. Darüber hinaus ist in der Gehäusewandung seitlich eine Öffnung 33 zur Aufnahme der Dichtungen 9 sichtbar.

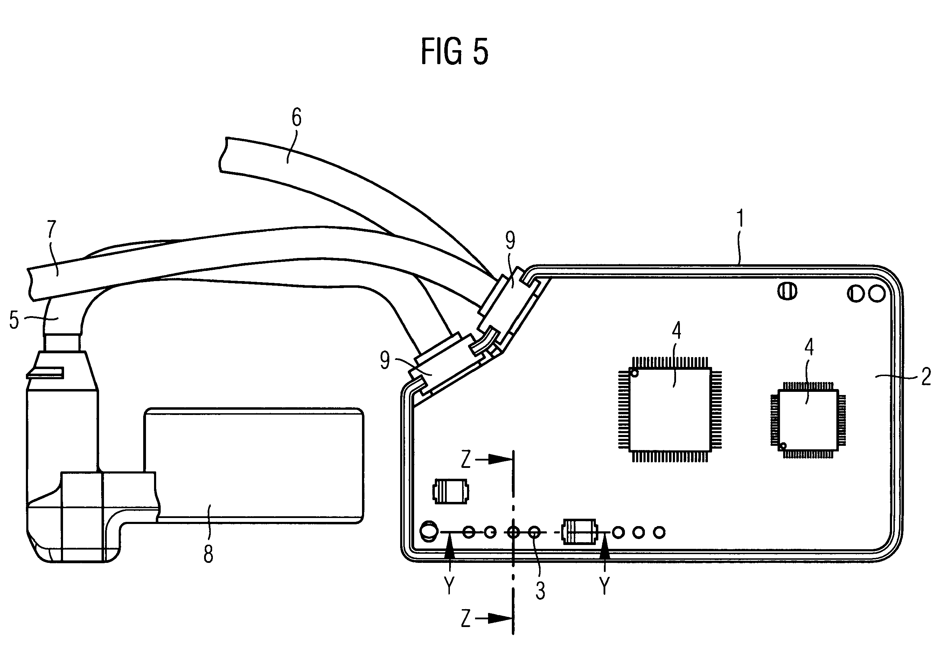

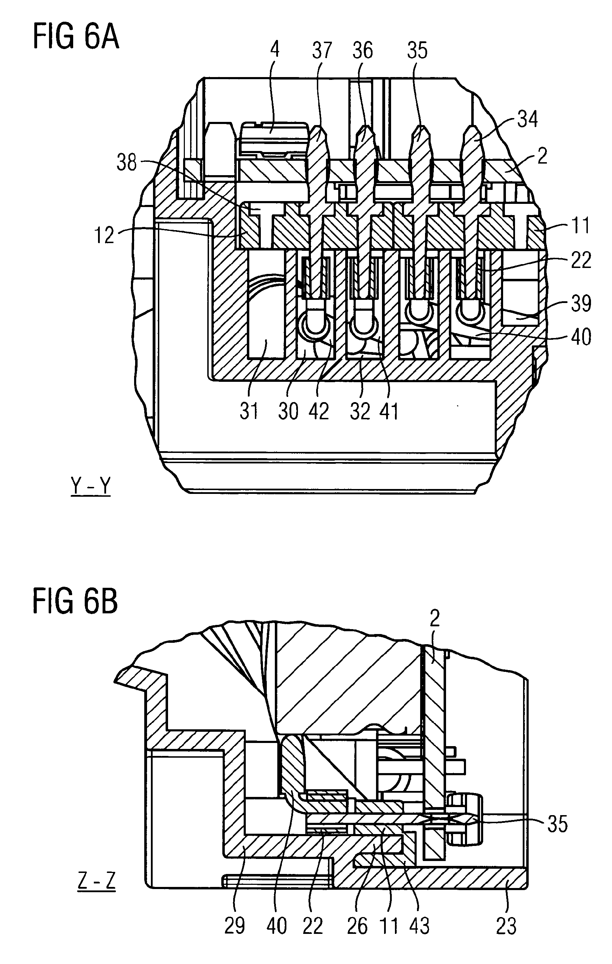

In Fig. 5 ist eine Draufsicht des Ausführungsbeispiels dargestellt, wobei insbesondere Schnittrichtungen Y und Z gekennzeichnet sind, welche im Zusammenhang mit Fig. 6 näher erläutert werden.

Fig. 6a zeigt einen Y - Y -Schnitt durch das Steuergerät. Darauf sind die Kontakthalter 12 und 11 zu erkennen, welche jeweils mit den Einpresspins 36 und 37 bzw. 34 und 35 in die Leiterplatte 2 eingreifen und dabei die elektrische Verbindung der Kabel 5 und 7 mit den Bauelementen 4 herstellen. Wie erkennbar, können die Einpresspins im Kabelhalter 12 bzw. 11 nach Bedarf bestückt werden. So liegt am Kabelkanal 31 keine elektrische Leitung an, weshalb hier der Kabelhalter an dieser Stelle unbestückt bleibt. An die Einpresspins 36 und 37 schließen sich die Adern 41 bzw. 42 des Kabels 5 an, während das Kabel 7 mit den Adern 39 und 40 an die Einpresspins 34 und 35 des Kontakthalters 11 führt.

Im Z - Z-Schnitt ist der Kabelhalter 11 dargestellt, welcher einen Zapfen 26 des Sockels 29 mit Hilfe einer Nase 43 umgreift und somit an der Gehäusewandung 23 arretiert ist. Auch hier ist sichtbar, dass der Einpresspin 35 die Leiterplatte 2 kontaktiert.

## Patentansprüche

1. Elektronische Vorrichtung mit einem Gehäuse zur Aufnahme eines, eine elektronische Schaltung tragenden Trägersubstrates, wobei die elektronische Schaltung mit mindestens einer elektrischen Leitung kontaktiert ist, welche aus dem Gehäuse herausgeführt ist, **dadurch gekennzeichnet, dass** die elektrische Leitung (13, 14, 15; 39, 40; 41, 42) mit einem starren Kontaktelement (19, 20, 21; 34, 35; 36, 37) eines Kontakthalters (10, 11, 12) verbunden ist und das Kontaktelement (19, 20, 21; 34, 35; 36, 37) zur Kontaktierung der elektronischen Schaltung (4) in das Trägersubstrat (2) eingeführt ist.

2. Vorrichtung nach Anspruch 1, **dadurch gekennzeichnet, dass** das Kontaktelement (19, 20, 21; 34, 35; 36, 37) den Kontakthalter (10, 11, 12) mindestens einseitig überragt, wobei die elektrische Leitung (13, 14, 15; 39, 40; 41, 42) an einem Ende mit dem Kontaktelement (19, 20, 21; 34, 35; 36, 37) verbunden ist.

3. Vorrichtung nach Anspruch 1 oder 2, **dadurch gekennzeichnet, dass** das Kontaktelement (19, 20, 21; 34, 35; 36, 37) als Einpresselement ausgebildet ist.

4. Vorrichtung nach Anspruch 2, **dadurch gekennzeichnet, dass** das Kontaktelement (19, 20, 21; 34, 35; 36, 37) und die elektrische Leitung (13, 14, 15; 39, 40; 41, 42) verlötet oder verschweißt sind.

5. Vorrichtung nach Anspruch 2, **dadurch gekennzeichnet, dass** die elektrische Leitung (13, 14, 15; 39, 40; 41, 42) parallel zu dem einen Ende des Kontaktelements (19, 20, 21; 34, 35; 36, 37) positioniert ist, wobei beide miteinander vercrimpt oder versplicet sind.

6. Vorrichtung nach Anspruch 1, **dadurch gekennzeichnet, dass** der Kontakthalter (10, 11, 12) in eine, an einer Gehäusewandung (23) angeordnete Kontakthalteraufnahme (24, 25) eingesetzt und das Trägerelement (2) auf dem Kontakthalter (10, 11, 12) aufgesetzt ist.

7. Vorrichtung nach Anspruch 6, **dadurch gekennzeichnet, dass** der Kontakthalter (10, 11, 12) einen Aufsteckzapfen (26, 27) der Kontakthalteraufnahme (24, 25) hintergreift.

8. Vorrichtung nach Anspruch 6 oder 7, **dadurch gekennzeichnet, dass** die Kontakthalteraufnahme (24, 25) einen Sockel (29) aufweist, in welchem eine Kabelaufnahme (30, 31, 32)ausgebildet ist.

9. Vorrichtung nach Anspruch 1, **dadurch gekennzeichnet, dass** über ein, mehrere elektrische Leitungen (13, 14, 15; 39, 40; 41, 42) zusammenfassendes Kabel (5, 6, 7) eine Dichtung (9) geschoben ist, welche in eine Öffnung (33) der Gehäusewandung eingeschoben ist.

## Claims

1. Electronic device having a housing for accommodating a support substrate which supports an electronic circuit, with at least one electrical line, which is routed out of the housing, making contact with the electronic circuit, **characterized in that** the electrical line (13, 14, 15; 39, 40; 41, 42) is connected to an inflexible contact element (19, 20, 21; 34, 35; 36, 37) of a contact holder (10, 11, 12), and the contact element (19, 20, 21; 34, 35; 36, 37) is inserted into the support substrate (2) in order to make contact with the electronic circuit (4).

2. Device according to claim 1, **characterized in that** the contact element (19, 20, 21; 34, 35; 36, 37) projects beyond the contact holder (10, 11, 12) at least on one side, with the electrical line (13, 14, 15; 39, 40; 41, 42) being connected to the contact element (19, 20, 21; 34, 35; 36, 37) at one end.

3. Device according to claim 1 or 2, **characterized in that** the contact element (19, 20, 21; 34, 35; 56, 37) is in the form of a press-in element.

4. Device according to claim 2, **characterized in that** the contact element (19, 20, 21; 34, 35; 36, 37) and the electrical line (13, 14, 15; 39, 40; 41, 42) are soldered or welded.

5. Device according to claim 2, **characterized in that** the electrical line (13, 14, 15; 39, 40; 41, 42) is positioned parallel to one end of the contact element (19, 20, 21; 34, 35; 36, 37), with said electrical line and contact element being crimped or spliced to one another.

6. Device according to claim 1, **characterized in that** the contact holder (10, 11, 12) is inserted into a contact holder receptacle (24, 25) which is arranged on a housing wall arrangement (23), and the support element (2) is placed on the contact holder (10, 11, 12).

7. Device according to claim 6, **characterized in that** the contact holder (10, 11, 12) engages behind a plug-on peg (26, 27) of the contact holder receptacle (24, 25).

8. Device according to claim 6 or 7, **characterized in that** the contact holder receptacle (24, 25) has a base (29) in which a cable receptacle (30, 31, 32) is formed.

9. Device according to claim 1, **characterized in that** a seal (9), which is pushed into an opening (33) in the housing wall arrangement, is pushed over a cable (5, 6, 7) which combines a plurality of electrical lines (13, 14, 15; 39, 40; 41, 42).

## Revendications

1. Dispositif électronique comportant un boîtier destiné à abriter un substrat supportant un circuit électronique, où le circuit électronique est en contact électrique avec au moins un conducteur électrique qui sort du boîtier, **caractérisé par le fait que** le conducteur électrique (13, 14, 15; 39, 40; 41, 42) est relié à un élément de contact rigide (19, 20, 21; 34, 35; 36, 37) d'un support de contacts (10, 11, 12) et l'élément de contact (19, 20, 21; 34, 35; 36, 37) est introduit dans le substrat support (2) pour la mise en contact électrique du circuit électronique (4).

2. Dispositif selon la revendication 1, **caractérisé par le fait que** l'élément de contact (19, 20, 21; 34, 35; 36, 37) dépasse au moins d'un côté le support de contacts (10, 11, 12), le conducteur électrique (13, 14, 15; 39, 40; 41, 42) étant relié à une extrémité à l'élément de contact (19, 20, 21; 34, 35; 36, 37).

3. Dispositif selon la revendication 1 ou 2, **caractérisé par le fait que** l'élément de contact (19, 20, 21; 34, 35; 36, 37) est un élément à enfoncer.

4. Dispositif selon la revendication 2, **caractérisé par le fait que** l'élément de contact (19, 20, 21; 34, 35; 36, 37) et le conducteur électrique (13, 14, 15; 39, 40; 41, 42) sont soudés ou brasés.

5. Dispositif selon la revendication 2, **caractérisé par le fait que** le conducteur électrique (13, 14, 15; 39, 40; 41, 42) est mis en place parallèlement à l'une des extrémités de l'élément de contact (19, 20, 21; 34, 35; 36, 37), les deux étant sertis ou épissés l'un avec l'autre.

6. Dispositif selon la revendication 1, **caractérisé par le fait que** le support de contacts (10, 11, 12) est inséré dans un logement de support de contacts (24, 25) placé sur une paroi du boîtier (23) et que l'élément support (2) est enfiché sur le support de contacts (10, 11, 12).

7. Dispositif selon la revendication 6, **caractérisé par le fait que** le support de contacts (10, 11, 12) s'agrippe derrière un pivot à enficher (26, 27) du logement de support de contacts (24, 25).

8. Dispositif selon la revendication 6 ou 7, **caractérisé par le fait que** le logement de support de contacts (24, 25) a un socle (29) dans lequel est ménagé un logement de câble (30, 31, 32).

9. Dispositif selon la revendication 1, **caractérisé par le fait qu'**un joint (9) est enfilé sur un câble (5, 6, 7) rassemblant plusieurs conducteurs électriques (13, 14, 15; 39, 40; 41, 42) et est inséré dans une ouverture (33) de la paroi du boîtier.
